# EUROPÄISCHE PATENTSCHRIFT

(11) **EP 2 569 604 B1**
(45) Veröffentlichungstag und Bekanntmachung des Hinweises auf die Patenterteilung: **23.10.2019**
(21) Anmeldenummer: 11724535.7
(22) Anmeldetag: 11.05.2011
(51) Int. Cl.: G01F 1/66, B06B 1/06, H01L 41/047

(54) **ULTRASCHALL-DURCHFLUSSMESSER**
ULTRASOUND FLOWMETER
DÉBIT-MÈTRE À ULTRASONS

(30) Priorität: 10.08.2010 DE 102010033858; 21.07.2010 DE 102010031753; 12.05.2010 DE 102010020338
(43) Veröffentlichungstag der Anmeldung: 20.03.2013
(73) Patentinhaber: Diehl Metering GmbH, 91522 Ansbach (DE)
(72) Erfinder: KROEMER, Harald, 91522 Ansbach (DE); ÖFELEIN, Wilhelm, 91522 Ansbach (DE); HOFMANN, Tino, 91413 Neustadt/Aisch (DE); SCHMIDT-SCHOENIAN, Axel, 91732 Merkendorf (DE); HORN, Roland, 91629 Weihenzell (DE); DIETZ, Gerhard, 91586 Lichtenau (DE); SONNENBERG, Hans-Michael, 91522 Ansbach (DE)
(74) Vertreter: Diehl Patentabteilung
(86) Internationale Anmeldenummer: PCT/EP2011/002333
(87) Internationale Veröffentlichungsnummer: WO 2011/141167

(56) Entgegenhaltungen:
- EP-A1- 0 260 335
- EP-A1- 0 532 971
- DE-U1- 29 611 678
- JP-A- 2005 189 090

## Beschreibung

Die vorliegende Erfindung betrifft einen Ultraschall-Durchflussmesser mit einem aus Kunststoff bestehenden Gehäuse und mit einer Ultraschallwandleranordnung.

### Technologischer Hintergrund

Die Abdichtung und Kontaktierung von Ultraschall-Durchflussmessern ist ein technisch anspruchsvoller und aufwändiger Prozess. Gehäuseöffnungen müssen mit filigranen Dichtungselementen aus bestem Dichtmaterial abgedichtet werden. Durch den vermehrten Einsatz von Kunststoffmaterialien, bei denen üblicherweise Fertigungstoleranzen nicht ausgeschlossen werden können, kann es aufgrund der kleinen Dimensionen der Dichtungselemente leicht zu Undichtigkeiten bei bestimmten Betriebsbedingungen kommen. Auch bei der Auswahl von hoch qualitativem Dichtmaterial und zeitaufwändigen manuellen Bearbeitungen können Undichtigkeiten dennoch nicht ausgeschlossen werden.

In den vergangenen Jahren ist man dazu übergegangen, Ultraschallwandler im Gehäuse zu positionieren, damit der vom Ultraschallwandler erzeugte Ultraschallburst durch eine dünne, regelmäßig aus Kunststoff bestehende Gehäusewand hindurch in das Medium eintritt.

### Stand der Technik

Aus der EP 2 236 993 A1 sowie der EP 2 236 995 A1 ist jeweils ein Ultraschallzähler bekannt, welcher ein einteiliges Gehäuse sowie eine davon separate die beiden Ultraschallwandlerkörper sowie die Platine umfassende Montageeinheit beinhaltet. Die beiden Ultraschallwandlerkörper befinden sich in entsprechenden Ausschnitten in der Platine und werden durch ober- und unterseitige Halteklammern fixiert. Die die Ultraschallwandlerkörper sowie Platine umfassende Montageeinheit wird auf einen ebenen Gehäusebereich aufgesetzt, derart, dass die Ultraschallwandler das Gehäuse im Bereich des ebenen Gehäusebereichs durchschallen.

Aus der EP 0 708 313 ist ein entsprechendes Ultraschall-Durchflussmessgerät bekannt, bei dem im üblicherweise aus Guss bestehenden Gehäuse desselben Ultraschallwandler unter Zuhilfenahme einer zugehörigen Überwurfmutter sowie eines O-Rings in jedem einzelnen Ultraschallwandler zugeordnete Öffnungen eingesetzt werden. Ein Temperaturfühler ist ebenfalls in einer zugehörigen Gehäuseöffnung untergebracht. Diese Konstruktion begründet eine Vielzahl von Einzelteilen. Darüber hinaus erfordert sie eine aufwändige Verarbeitung des Gehäuses.

Aus der EP 2 037 231 A1 ist ein Gehäuse für einen Ultraschall-Durchflussmesser bekannt, bei dem ein einstückiges, monolithisches Gehäuse mit an der Außenseite angeordneten, planen Kontaktstellen für die Positionierung von Ultraschallwandlern eingesetzt wird. Die Ultraschallwandler werden in einem bestimmten Abstand entlang des Gehäuses an dessen Außenseite befestigt und durchschallen im Betrieb die Gehäusewandung.

Aus der DE 10 2005 001 895 B4 ist eine Vorrichtung zur Durchflussmessung bekannt, bei der der Fluidstrom um eine senkrecht zur Strömungsrichtung positionierte Strömungstrennwand herum geleitet wird. An der Stirnseite der Strömungstrennwand befindet sich eine Ultraschallwandleranordnung in einer Gehäuseaussparung. Die Ultraschallwandleranordnung umfasst lediglich einen Piezoschwinger mit einer einzigen Masseelektrode sowie zwei flächig nebeneinander angeordnete und voneinander getrennte Signalelektroden, wobei jeder Signalelektrode eine Abstrahlfläche bzw. Empfangsfläche für Ultraschallsignale zugeordnet ist.

Aus der EP 0 890 826 B1 ist ein Ultraschall-Durchflussmesser mit einem Messeinsatz aus Kunststoff bekannt. Der Messeinsatz befindet sich in einer Ausnehmung des Gehäuses des Durchflussmessers und ist zu diesem einlaufseitig über eine einzige Dichtung abgedichtet. Zusätzlich verfügt der Messeinsatz über einen Deckel, der zum Messeinsatz über eine umlaufende Dichtung abgedichtet ist. In dem Deckel befinden sich zwei Durchbrüche, in die ebenfalls unter Einfügung einer Dichtung je ein einen Ultraschallwandlerkörper sowie ein zugehöriges Gehäuse umfassender Ultraschallwandler eingesetzt wird.

Die DE 296 11 678 U1 wie auch die EP 0 260 335 A1 beschreiben Schallwandler mit Metall- oder Keramikgehäusen, die in Öffnungen einer Fluid führenden Rohrwand angeordnet sind. Innerhalb des Metall- bzw. Keramikgehäuses ist dabei jeweils ein piezoelektrisches Element angeordnet und kontaktiert. Diese Ultraschallwandler müssen vorab zusammengebaut und beim Einsetzen in die Rohröffnungen aufwändig abgedichtet werden. Die Produktion eines Ultraschall-Durchflussmessers mit diesen Ultraschallwandlern ist somit aufwändig und teuer.

In der EP 0 532 971 A1 ist ein Festkörper-Motorbetätiger beschrieben, der eine progressive Elektrodenstruktur zum Anlegen von Spannung an piezoelektrische Festkörper-Motorstapel zum Erzeugen einer Betätigung aufweist. Dabei sind eine Vielzahl von piezoelektrischen Scheiben vorgesehen, zwischen denen flächige Anschlusselektroden angeordnet und kontaktiert sind. Der Stapel aus piezoelektrischen Scheiben ist in einem Stahlgehäuse untergebracht und dort mittels eingespritztem Silikon eingekapselt.

Die JP 2005189090 A beschreibt einen Ultraschall-Wasserzähler mit einer U-förmigen Ultraschall-Messstrecke. Am Anfang und am Ende dieser U-förmigen Messstrecke sind jeweils Ultraschallwandler in Öffnungen in der Messstreckenwand angeordnet. Auch diese bedürfen einer vorherigen Montage und aufwändigen einzelnen Abdichtung beim Einbau in den Wasserzähler.

### Aufgabe

Die Aufgabe der vorliegenden Erfindung besteht darin, einen neuartigen Ultraschall-Durchflussmesser der gattungsgemäßen Art zur Verfügung zu stellen, der eine Reduzierung der Produktionskosten ermöglicht.

### Gegenstand der Erfindung

Die vorstehende Aufgabe wird durch die Merkmale des Anspruchs 1 gelöst. Zweckmäßige Ausgestaltungen der vorliegenden Erfindung ergeben sich aus den Unteransprüchen sowie der Beschreibung.

Dadurch, dass die ersten Kontaktmittel des Ultraschallwandlerkörpers in das Gehäuse, in ein Gehäuseteil oder in einen Gehäuseeinsatz eingelegt oder dort festgelegt sind, ist es möglich, einfach ausgebildete Ultraschallwandlerkörper zu verwenden, insbesondere müssen die Ultraschallwandlerkörper keine Umkontaktierung mehr aufweisen. Ebenso ist es nicht mehr notwendig, separate Ultraschallwandler als fertig einzusetzende Bauteile herzustellen. Aufgrund der Wanddurchschallung entfallen aufwändige Dichtungsmaßnahmen. Die Teileanzahl und die Fertigungsschritte reduzieren sich auf ein Minimum. Ausfallrisiken aufgrund Schäden durch eine mit der Zeit defekt werdende Klebe- oder Lötverbindung der Elektrode am Ultraschallwandlerkörper reduzieren sich. Die Betriebszuverlässigkeit steigt.

Sofern als erste Kontaktmittel des Ultraschallwandlerkörpers eine lose Elektrode vorgesehen ist, kann diese in einfacher Weise in eine dafür vorgesehene Vertiefung am Gehäuse oder eines Teils desselben oder am Gehäuseeinsatz eingelegt und dort zwischen dem Ultraschallwandlerkörper und der zu durchschallenden Gehäusewand lagefixiert werden.

Alternativ kann als das erste Kontaktmittel eine bereits auf das Gehäuse oder auf das Gehäuseteil oder auf den Gehäuseeinsatz vorher aufgebrachte Kontaktschicht vorgesehen sein. Hierbei kann es sich zweckmäßigerweise um eine z. B. aus einer Gasphase niedergeschlagene leitfähige Schicht wie etwa eine durch metallische Bedampfung aufgebrachte, fest mit dem Gehäuse oder Gehäuseteil oder Gehäuseeinsatz (vor)verbundene Kontaktschicht handeln. Alternativ kann eine leitfähige Schicht durch Plattieren, durch thermisches Metallverspritzen oder durch einen Schmelztauchüberzug erfolgen. Auch eine Pulverbeschichtung aus leitfähigem Material kann zum Einsatz kommen. Hierdurch kann der Ultraschallwandlerkörper in einfacher Weise an das die Kontaktmittel tragende Gehäuse angelegt oder in dieses eingelegt werden.

Als weitere alternative Ausgestaltung können die ersten Kontaktmittel auch als in das Gehäuse oder in das Gehäuseteil oder in den Gehäuseeinsatz integrierte Leiterschicht oder Leiterstruktur vorgesehen sein. Zum Einsatz können hierfür der 2-Komponenten-Spritzguss, das sog. MID Verfahren, das Heißprägeverfahren, das Verfahren der Maskenbelichtung, die Laserstrukturierung oder das Folienhinterspritzen kommen. Auch hierdurch kann der Ultraschallwandlerkörper in einfacher Weise an das die Kontaktmittel tragende Gehäuse bzw. Gehäuseteil angelegt oder in dieses eingelegt werden.

Die Fixierung des Ultraschallwandlerkörpers kann unter einer in Axialrichtung wirkenden Vorspannung auf der eingelegten Elektrode oder auf der die Kontaktmittel tragenden Gehäusewand erfolgen. Zweckmäßigerweise erfolgt die Fixierung über eine Feder, welche gleichzeitig einen elektrischen Kontakt der einen Seite des Ultraschallwandlerkörpers gewährleistet.

Der Anschluss der ersten Kontaktmittel erfolgt über eine Anschlussfahne z. B. über eine an die Elektrode einstückig angeformte und nach oben abstehende Anschlussfahne oder über ein selbstzentrierendes Anschlussmittel wie z. B. einer Feder insbesondere in Form einer sog. Spiralfeder. Letztere verläuft entlang des Außenumfangs des Ultraschallwandlerkörpers.

Gemäß einem weiteren Aspekt der vorliegenden Erfindung ist der Ultraschallwandlerkörper in einem insbesondere topfförmigen, durchschallbaren und aus Kunststoff bestehenden Gehäuseeinsatz untergebracht. Dieser Gehäuseeinsatz wird in eine entsprechende Gehäuseöffnung eingesetzt, wodurch ein mehrteiliges Gehäuse mit einer sacklochartigen Vertiefung im Bereich des jeweiligen Wandlerkörpers erzeugt werden kann. Der durchschallbare, aus Kunststoff bestehende Gehäuseeinsatz bietet auch Produktionsvorteile unabhängig von der Ausbildung der Elektrode. Beispielsweise auch dann, wenn die Elektrode fest an dem Ultraschallwandler befestigt ist oder eine Kontaktierung über eine von der Unterseite nach oben geführte Metallisierung (Umkontaktierung) erfolgt.

Zum oberseitigen Verschluss des Gehäuseeinsatzes kann ein Verschlussteil oder ein Deckel vorgesehen sein. Hierbei können die Anschlüsse an der Oberseite des Verschlussteils herausgeführt sein. Die erfindungsgemäße Wandleranordnung kann hierdurch in einfacher Weise als eigenständig handhabbares, lediglich noch an der Platine zu kontaktierendes Bauteil (selbständige Montageeinheit) hergestellt werden. Das übrige Gehäuse kann hierdurch eine einfachere Form besitzen, wodurch wiederum die Herstellungskosten des Gehäuses beträchtlich reduziert werden können.

Zudem kann der den Ultraschallwandlerkörper umgebende Raum zumindest zum Teil mit Vergussmasse ausgefüllt sein. Hierdurch können Oxidationserscheinungen vermieden werden.

Der Gehäuseeinsatz kann entweder je nach Bedarf zwei Ultraschallwandlerkörper oder aber eine Mehrzahl (insbesondere aber ein Ultraschallwandlerkörper-Paar) aufweisen.

Gemäß einem weiteren Aspekt der vorliegenden Erfindung ist bei einer Anordnung, die einen ersten und zweiten Ultraschallwandlerkörper umfasst, eine für den ersten und zweiten Ultraschallwandlerkörper gemeinsame, gehäuseseitig festgelegte elektrischen Kontaktierung (beispielsweise Massepotential) der jeweils ersten Hauptfläche des betreffenden Ultraschallwandlerkörpers vorgesehen. Hierdurch kann die Konstruktion erheblich vereinfacht werden.

### Ausführungsbeispiele der Erfindung

Nachstehend werden anhand von Zeichnungsfiguren zweckmäßige Ausgestaltungen der vorliegenden Erfindung näher erläutert. Hierbei werden der Übersichtlichkeit halber wiederkehrende Merkmale lediglich einmal mit einem Bezugszeichen versehen. Als erfindungswesentlich werden ausdrücklich auch Einzelmerkmalskombinationen bzw. Teilmerkmalskombinationen der nachstehend beschriebenen Ausgestaltungen angesehen.

Es zeigen:
- Fig. 1: eine Schnittdarstellung durch das Gehäuse eine Ultraschallzählers mit Wanddurchschallung;
- Fig. 2: eine Ultraschallwandleranordnung gemäß einer ersten Ausgestaltung der Erfindung während der Montage (Fig. 2A), nach der Montage (Fig. 2B) jeweils ohne Verschlussteil sowie in perspektivischer Explosionsdarstellung (Fig. 2C);
- Fig. 3: eine Ultraschallwandleranordnung gemäß einer zweiten Ausgestaltung der Erfindung in Schnittdarstellung (Fig. 3A) ohne Verschlussteil sowie in perspektivischer Explosionsdarstellung (Fig. 3B);
- Fig. 4: eine Ultraschallwandleranordnung gemäß einer dritten Ausgestaltung der Erfindung in Schnittdarstellung eines Bereichs eines Ultraschallwandlerkörpers (Fig. 4A) sowie im Falle einer gemeinsamen Kontaktierung zweier Ultraschallwandlerkörper;
- Fig. 5: eine Ultraschallwandleranordnung gemäß der vorliegenden Erfindung eines Ultraschalldurchflussmessers untergebracht in einer besonderen Ausgestaltung einer Gehäuseanordnung in perspektivischer Schnittdarstellung;
- Fig. 6: eine vergrößerte Schnittdarstellung des Bereichs A von Fig. 5;
- Fig. 7: eine Explosionsdarstellung der Einzelteile des Gehäuseeinsatzes gemäß der Ausgestaltung nach Fig. 5 bzw. Fig. 6 in perspektivischer Schnittdarstellung;
- Fig. 8: eine Stirnansicht des Gehäuseeinsatzes gemäß der Ausgestaltung nach den Figuren 5 bis 7;
- Fig. 9: eine zweite Ausgestaltung einer Gehäuseanordnung gemäß der vorliegenden Erfindung in perspektivischer Schnittdarstellung mit einer Ultraschallwandleranordnung gemäß der vorliegenden Erfindung;
- Fig. 10: eine vergrößerte Schnittdarstellung des Bereichs A von Fig. 9;
- Fig. 11: eine Explosionsdarstellung der Einzelteile des Gehäuseeinsatzes gemäß der Ausgestaltung nach Fig. 9 bzw. Fig. 10 in perspektivischer Schnittdarstellung;
- Fig. 12: eine Explosionsdarstellung der Einzelteile des Gehäuseeinsatzes gemäß einer weiteren Ausgestaltung der vorliegenden Erfindung,

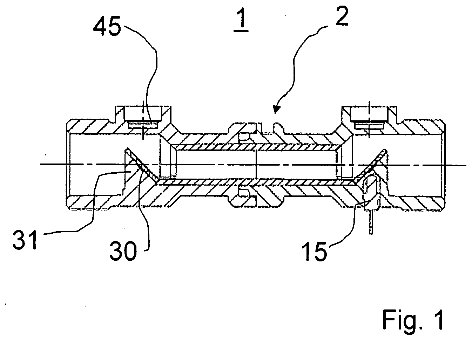

Fig. 1 zeigt das Gehäuse 2 eines Ultraschall-Durchflussmessers 1, welches aus zwei etwa in der Mitte zusammengefügten Teilen besteht. An der Oberseite des jeweiligen Gehäuseteils befindet sich eine taschenförmige Ausnehmung 45 für den Einsatz je eines (nicht dargestellten) Ultraschallwandlers. Der Boden der taschenförmigen Ausnehmung 45 des Gehäuses 2 ist dünnwandig ausgebildet, so dass eine Durchschallung in das den Ultraschall-Durchflussmesser durchströmende Medium ermöglicht wird. Im Gehäuse 2 befinden sich zwei Umlenkspiegel 30, die von Umlenkspiegelhaltern 31 getragen sind und das Ultraschallsignal (Ultraschallburst) zu einer U-förmigen Messstrecke umlenken. Ferner kann ein Temperaturfühler 15 in einer Gehäuseausnehmung untergebracht sein. Die beiden Teile des Gehäuses 2 bestehen zweckmäßigerweise aus einem Kunststoff insbesondere einem thermoplastischen Kunststoff, der im sog. Spritzgießverfahren verarbeitbar ist.

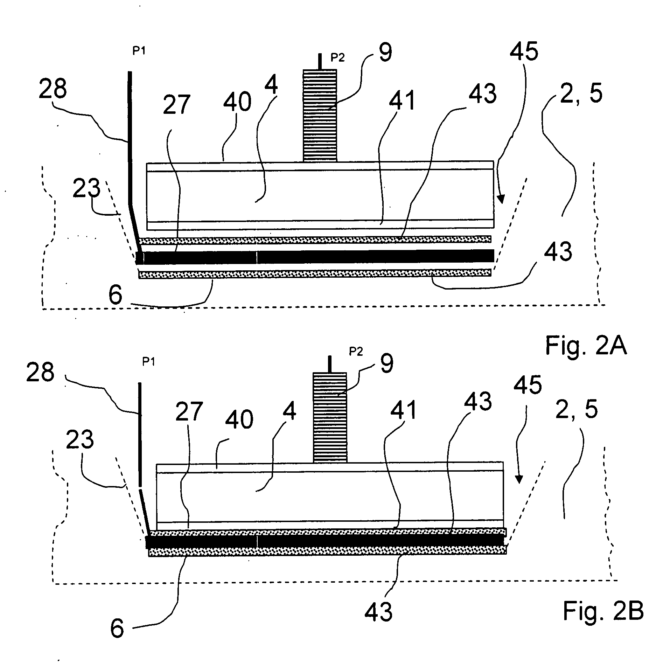

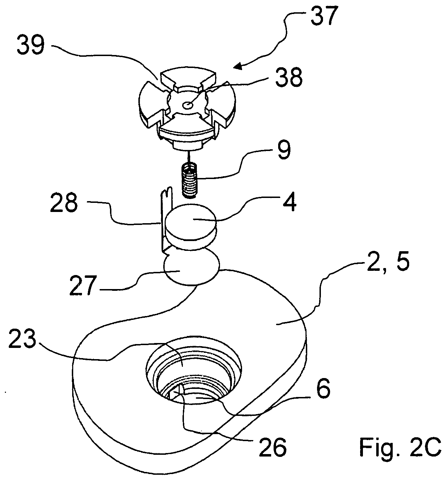

Fig. 2 zeigt eine erste Ausgestaltung der erfindungsgemäßen Ultraschallwandleranordnung, die sich in einem punktiert angedeuteten Gehäuse 2 oder Gehäuseteils oder Einsatzteils 5 im Gehäuse befindet. Gemäß Fig. 2A ist der Ultraschallwandlerkörper 4 also die Scheibe aus Piezokeramik mit einer fest angebrachten Metallisierung 40, 41 (z.B. Ag) sowohl an deren Ober- als auch Unterseite versehen. Das Gehäuse 2 bzw. Gehäuseteil bzw. das Einsatzteil 5 weist bei dieser Ausgestaltung eine taschenförmige Ausnehmung 45 mit einer Auflagefläche 6 sowie schräg nach außen verlaufenden Flächen 23 auf. Zur elektrischen Kontaktierung des Ultraschallwandlerkörpers 4 ist eine lose Elektrode 27 vorgesehen, die in die schräg nach innen sich verjüngende Ausnehmung 45 eingelegt und an der Auflagefläche 6 flächig aufgesetzt wird. Zur Kontaktierung (elektrisches Potential P1) verfügt die Elektrode 27 über eine seitlich angeordnete Anschlussfahne 28. Letztere ist einstückig mit der Elektrode 27 ausgebildet. Die Gegenkontaktierung (elektrisches Potential P2) der gegenüberliegenden Fläche des Ultraschallwandlerkörpers 4 erfolgt mit einer Feder 9 in Form einer Spiralfeder. Erforderlichenfalls kann, wie in Fig. 2 dargestellt, beidseitig der Elektrode 27 zusätzlich eine Schallkopplungsmasse 43 z.B. in Form eines Schallkopplungsgels oder dergleichen vorgesehen sein. Die nach innen verlaufende Verjüngung der Ausnehmung 45 trägt dazu bei, dass beim Einlegen der Elektrode 27 eine Zentrierung derselben erfolgt.

Die Feder 9 dient nicht nur zur elektrischen Kontaktierung der Oberseite des Ultraschallwandlerkörpers 4 sondern auch zu einer Lagefixierung desselben innerhalb der taschenförmigen Vertiefung 45.

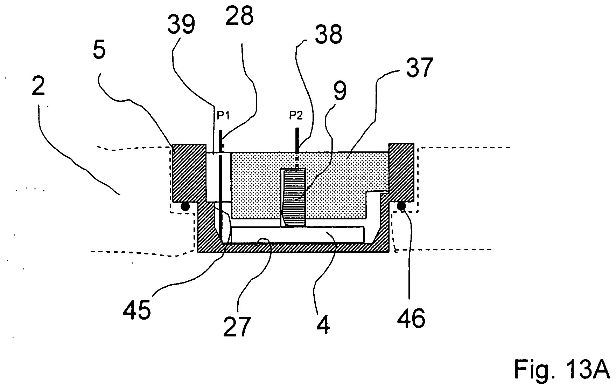

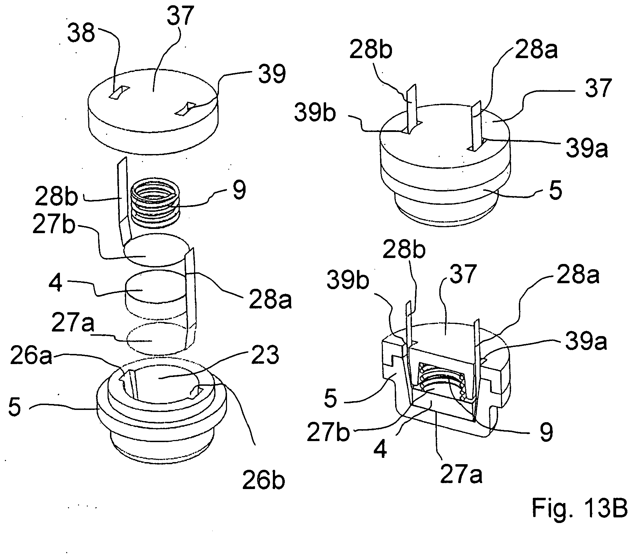

Wie aus Fig. 2C ersichtlich ist, kann zum Verschluss des Gehäuses 2 bzw. Gehäuseteils bzw. des Einsatzteils 5 an der Oberseite der Anordnung ein Deckel oder Verschlussteil 37 vorgesehen sein. Dieser umfasst eine innenseitige (nicht dargestellte) Ausnehmung (vgl. auch Fig. 13) zur Zentrierung der Feder 9 an der Deckelinnenseite. Über eine mittige Bohrung 38 kann das geradlinige Anschlussstück der Feder 9 nach außen geführt und vorzugsweise direkt mit der Platine (nicht dargestellt) kontaktiert werden. Des Weiteren sind umfänglich z.B. insgesamt vier radiale Ausschnitte 39 vorgesehen, die es ermöglichen, die Anschlussfahne 28 der Elektrode 27 durch das Verschlussteil 37 nach außen hin zur Platine zu führen.

Im Inneren des Gehäuses 2 bzw. Gehäuseteils bzw. Einsatzteils 5 befindet sich eine Vertiefung 26, die es ermöglicht, dass die Anschlussfahne 28 mit einem gewissen seitlichen Versatz vom Bereich der Auflagefläche 6 nach oben geführt werden kann.

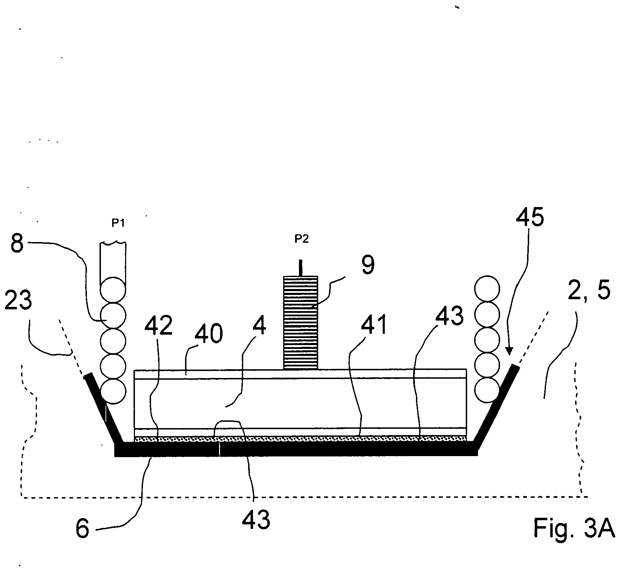

Fig. 3A zeigt stark vereinfacht eine weitere Ausgestaltung der erfindungsgemäßen Ultraschallwandleranordnung. Statt einer lose eingelegten Platine ist bei dieser Ausgestaltung eine auf das Gehäuse 2 bzw. Gehäuseteil bzw. Einsatzteil 5 z.B. durch metallische Bedampfung des Bodens der taschenförmigen Vertiefung 45 aufgebrachte Kontaktschicht 42 vorgesehen. Diese Kontaktschicht 42 kann sich entlang der schräg verlaufenden Fläche 23 zudem über einen Teil derselben nach oben erstrecken. Die elektrische Kontaktierung (elektrisches Potential P1) der Kontaktschicht 42 erfolgt beispielsweise mittels einer äußeren Feder 8, z.B. einer Spiralfeder, die den Ultraschallwandlerkörper 34 außenseitig umgreift. Die Kontaktierung (elektrisches Potential P2) mittels der Feder 9 entspricht der bereits eingangs beschriebenen Ausgestaltung. An der Oberseite der Kontaktschicht 42 kann sich zweckmäßigerweise eine Schallkopplungsmasse 43 befinden.

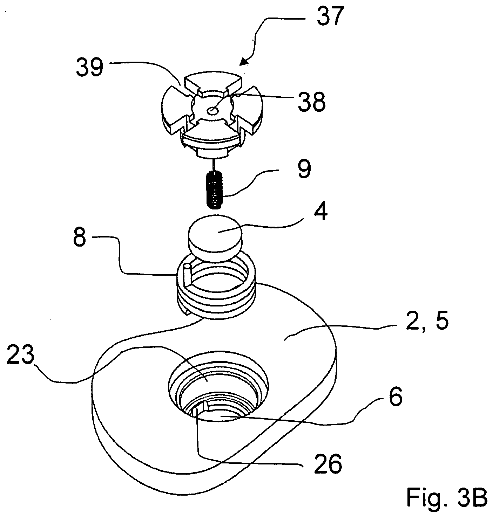

Wie aus Fig. 3B ersichtlich wird die Feder 8 im Bereich der Fläche 23 angelegt und bietet einen ausreichend großen Innenraum, der es ermöglicht, dass der Ultraschallwandlerkörper 4 auf der Auflagefläche 6 des Gehäuses 2 aufliegt. Der Deckel 37 entspricht der Ausgestaltung des Deckels 37 gemäß Fig. 2C.

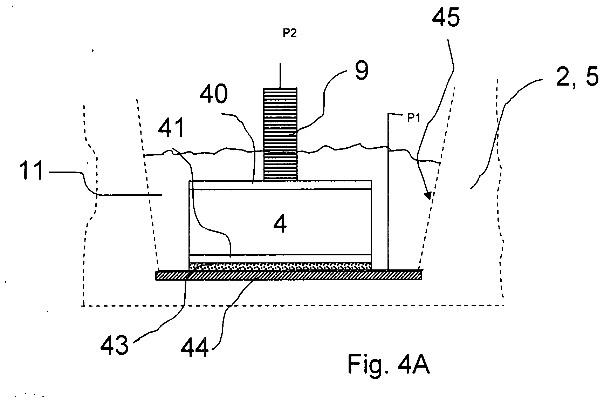

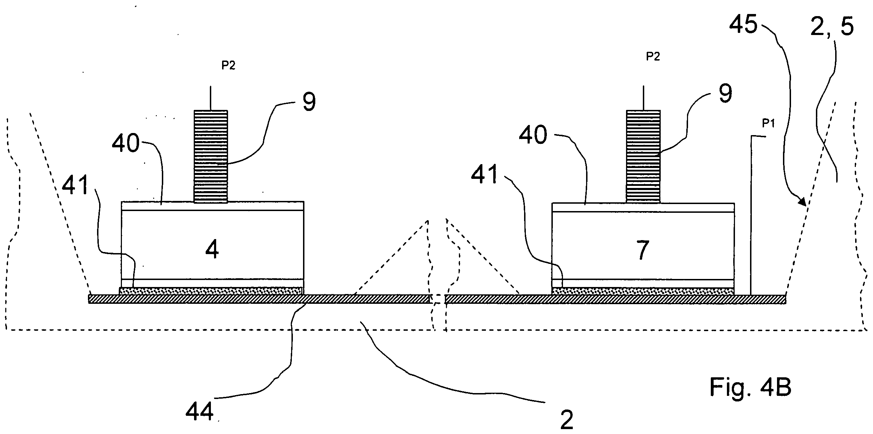

Bei der Ausgestaltung gemäß Fig. 4A wird die Kontaktierung der dem Medium zugewandten Seite des Ultraschallwandlerkörper 4 durch eine in das Gehäuse 2 bzw. Gehäuseteil bzw. Einsatzteil 5 integrierte Leiterbahnstruktur 44 erzielt. Diese Leiterbahnstruktur 44 ist im Kunststoff des Gehäuses bereits bei der Herstellung desselben verankert worden. Bei dem Gehäuse handelt es sich hierbei folglich um ein Bauteil, bei dem metallische Leiterbahnen auf einen spritzgegossenen Kunststoffträger aufgetragen worden sind. Dies erfolgt beispielsweise im sogenannten 2-Komponenten-Spritzguss, im Heißprägeverfahren, im Verfahren der Maskenbelichtung, im Verfahren der Laserstrukturierung oder des Folienhinterspritzens. Die Kontaktierung (elektrisches Potential P1) der Leiterbahnstruktur 44 kann auf verschiedenartige Weise erfolgen z.B. über eine Feder, wie sie in den Fig. 3A sowie 3B dargestellt ist. Auch hier kann zwischen Ultraschallwandlerkörper 4 und Leiterbahnstruktur 44 eine Schallkopplungsmasse 43 vorgesehen sein.

Diese Ausgestaltung erlaubt es zudem, eine Leiterbahnstruktur 44 entlang des gesamten Gehäuses 2 bzw. Gehäuseteils bzw. Einsatzteils 5 vorzusehen. Vorteilhaft können hierbei mit lediglich einer einzigen Kontaktierung (elektrisches Potential P1) beide Ultraschallwandlerkörper 4, 7 mit nur einer gemeinsamen Anschlusselektrode angeschlossen werden. Beispielsweise kann die elektrische Kontaktierung P1 ein gemeinsamer Massekontakt sein.

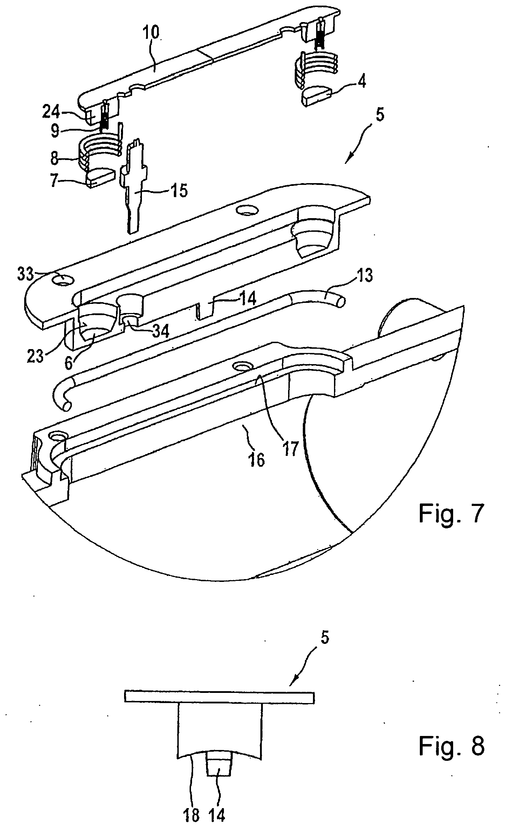

Bei den vorstehend wiedergegebenen Figuren 1 bis 7 handelt es sich um Längsschnitte von verschiedenen Ausgestaltungen der erfindungsgemäßen Ultraschallwandleranordnungen, bei denen Einsatzteile 5 vorgesehen sind, die zwei Ultraschallwandlerkörper 4, 7 beherbergen. Bei Fig. 8 handelt es sich um einen Teillängsschnitt.

Bezugsziffer 1 in Fig. 1 bezeichnet einen Ultraschalldurchflussmesser, welcher in eine (nicht dargestellte) Fluidleitung, z.B. Warmwasserleitung und/oder Kaltwasserleitung zur Erfassung der Durchflussmenge an Fluid ortsfest installiert wird. Der Ultraschalldurchflussmesser 1 weist hierzu ein längliches rohrförmiges Gehäuse 2 auf. Über geeignete (nicht dargestellte) Verbindungsmittel an den Stirnseiten des Gehäuses wird dieses mit dem Fluidleitungsnetz verbunden.

Der Ultraschalldurchflussmesser 1 verfügt über einen im Inneren des Gehäuses 2 befindlichen Messeinsatz 3, welcher bei der in Fig. 1 konkret dargestellten Ausführungsform einen ringförmigen, den Querschnitt verringernden Messabschnitt aufweist, der sich entlang des zwischen den beiden Umlenkspiegeln 30 befindlichen Raums erstreckt. Die Umlenkspiegel 30 werden von stromlinienförmig ausgebildeten Umlenkspiegelhaltern 31 getragen, die wiederum von einem Rahmen 32 gehalten werden, der gleichzeitig als Strömungsteiler dient.

Der Messeinsatz 3 wird zusammen mit den vorher bezeichneten Bestandteilen stirnseitig in das Gehäuse 2 des Ultraschalldurchflussmessers 1 eingeschoben.

An der Oberseite des Gehäuses 2 (vergleiche hierzu auch Fig. 7) befindet sich eine längliche Gehäuseöffnung 16, die dazu vorgesehen ist, einen Gehäuseeinsatz 5 aufzunehmen. Der Gehäuseeinsatz 5 dient dazu, die Ultraschallwandlerkörper 4, 7 am Ultraschalldurchflussmesser 1 zu positionieren. Bei den Ultraschallwandlerkörpern 4, 7 handelt es sich üblicherweise um Piezokeramikscheiben, die elektrische Energie in akustische Energie und umgekehrt umwandeln.

Der Gehäuseeinsatz umfasst des Weiteren einen Temperaturfühler 15, welcher durch eine Bohrung 34 im Bodenbereich des Gehäuseeinsatzes 5 hindurch sich in das Innere des Gehäuses 2 des Ultraschalldurchflussmessers 1 erstreckt und zum Gehäuseeinsatz 5 hin mittels eines Dichtungselements 35 abgedichtet ist. Zur Abdichtung des Gehäuseeinsatzes 5 zum Gehäuse 2 ist, vergleiche Fig. 3, ein einziges Dichtungselement 13 in Form eines in einer Stufe 17 umlaufenden, vergleichsweise groß dimensionierten O-Rings vorgesehen.

Der jeweilige Ultraschallwandlerkörper 4, 7 d. h. das jeweilige Piezokeramikplättchen befindet sich an der Oberseite einer Auflagefläche 6 an der Innenwand des topfförmigen Gehäuseeinsatzes 5. Diese ist vorzugsweise an den Durchmesser des Ultraschallwandlerkörper 4, 7 angepasst. Die Kontaktierung der (in den Zeichnungsfiguren nicht dargestellten) deckelseitigen Kontaktelektrode erfolgt über eine erste mittig angeordnete, in einem Halteteil 24 geführten Feder 9, die in zweckmäßiger Weise zum Abgriff des elektrischen Signals bzw. zur elektrischen Ansteuerung dient. Die Kontaktierung der ebenfalls in den Figuren nicht dargestellten zweiten Kontaktelektrode erfolgt über eine zweite spiralartige Feder 8, die den Massekontakt herstellt. Anstelle der zweiten Kontaktelektrode kann auch eine metallische Beschichtung der Innenwand des Gehäuseeinsatzes vorgesehen sein. Zur vereinfachten Montage ist oberhalb der Auflagefläche 6 eine abgeschrägte Fläche 23 vorgesehen, die durch Zentrierung das Einbringen und Positionieren des jeweiligen Ultraschallwandlerkörpers 4, 7 auf der Auflagefläche 6 erleichtert.

An der Oberseite des Gehäuseeinsatzes 5 befindet sich ein Deckel in Form einer Platine 10mit nicht dargestellten Kontaktbahnen, die eine unmittelbare Kontaktierung der Feder 8 sowie Feder 9 erlaubt.

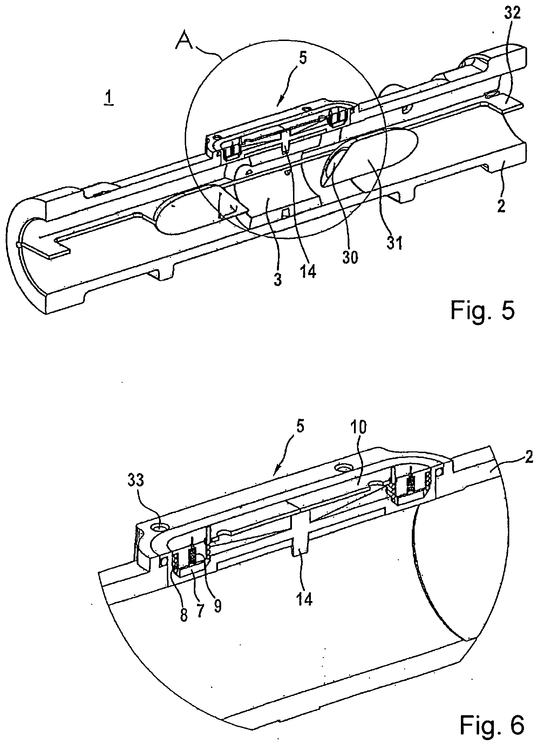

Wie aus Fig. 6 ersichtlich ist, wird der verbleibende Innenraum des Gehäuseeinsatzes 5 mit einer Vergussmasse 11 ausgefüllt, so dass sich die Ultraschallwandlerkörper 4, 7 sowie die Federn 8, 9 in Kontakt mit der Vergussmasse 11 befinden und die Bildung von Kondenswasser vermieden wird.

Anstelle der Platine 10 kann auch ein Deckel in Form eines Kunststoff-Spritzgussteils für einen oberen Abschluss des Gehäuseeinsatzes 5 vorgesehen sein.

Der Gehäuseeinsatz 5 wird mittels (nicht dargestellten) Schrauben sowie gegebenenfalls (ebenfalls nicht dargestellten) Halteteilen mit dem Gehäuse druckfest und wasserdicht verschraubt.

Ein am Bodenbereich vorspringender Zapfen 14 dient dazu, über eine korrespondierende (in den Figuren nicht dargestellte) Ausnehmung am Messeinsatz 3 letzteren im zusammengebauten Zustand in seiner Position zu fixieren.

Wie aus Fig. 8 ersichtlich ist, ist die Unterseite des Gehäuseeinsatzes 5 mit einer nach innen gewölbten Fläche 18 versehen, die im montierten Zustand des Gehäuseeinsatzes 5 mit der Außenfläche des Messeinsatzes 3 kontaktiert.

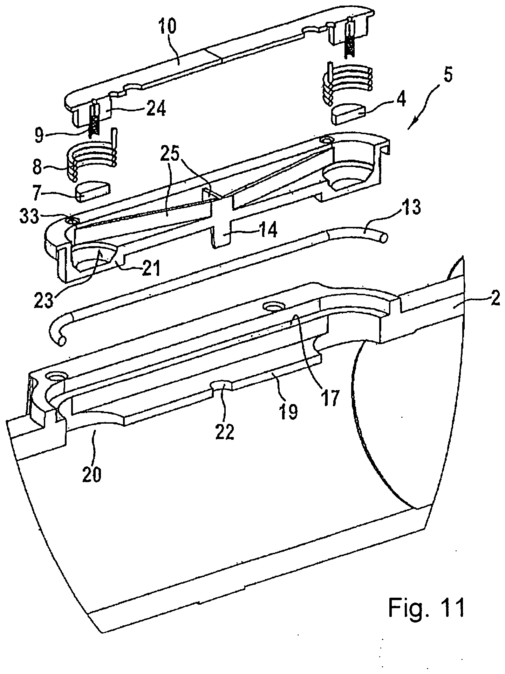

Bei der in den Figuren 1 bis 11 dargestellten Ausführungsvariante ist die Unterseite des Gehäuseeinsatzes 5 nicht an die Kontur des Messeinsatzes 3 angepasst. Das Gehäuse 2 weist eine Gehäuseinnenwand 19 auf, welche eine an die Außenkontur des Messeinsatzes 3 angepasste Innenkontur besitzt. Die Unterseite des Gehäuseeinsatzes 5 kann hierbei plan gestaltet sein. Die Gehäuseinnenwand 19 wird beim Ausfräsen der Gehäuseöffnung stehen gelassen, und zwar so, dass eine minimale Wandstärke, beispielsweise ca. 0,8 mm bis 1,2 mm auf der Mittellinie erhalten bleibt.

Der Messeinsatz 3 steht über entsprechende Dome 21, die in Durchtrittsöffnungen 20 in der Gehäuseinnenwand 19 eingreifen, mit dem Inneren des Ultraschalldurchflusszählers 1 in Kontakt. Die Dome 21 sind vorzugsweise so geformt, dass sie die Öffnungen 20 möglichst ausfüllen, um das Festsetzen von Luftblasen zu verhindern. Bei dieser Ausgestaltung kann der Gehäuseeinsatz 5 nach Art eines Moduls für unterschiedlichste Nenndurchmesser eingesetzt werden.

Die Kontaktierung der Ultraschallwandlerkörper entspricht derjenigen gemäß den Figuren 5 bis 8.

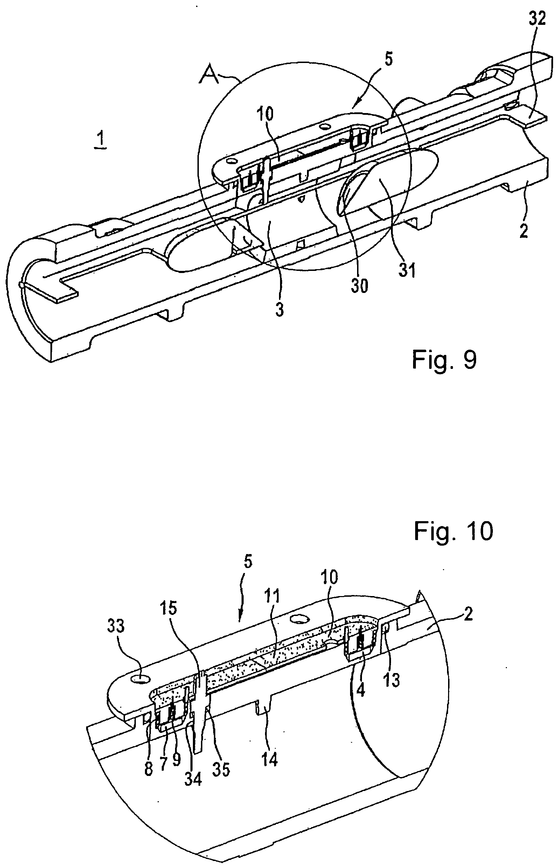

Um eine ausreichende Druckstabilität des Gehäuseeinsatzes zu gewährleisten, ist es zweckmäßig, diesen aus einem hochfesten, vorzugsweise mit einem Zusatzmaterial (z.B. Glasfasern) armierten Kunststoff herzustellen. Darüber hinaus ist es zweckmäßig, konstruktive Maßnahmen zur Erhöhung der Steifigkeit zu treffen, beispielsweise Versteifungsrippen 25 der beispielhaften Ausgestaltung gemäß den Figuren 9 bis 11. Solche verstärkenden Maßnahmen sind von Bedeutung, da der gesamte Druck des Fluids auf der Wandung des Gehäuseeinsatzes 5 lastet.

Alternativ oder zusätzlich kann der Gehäuseeinsatz 5 mit einer notwendigen Materialstärke versehen sein.

Im Bereich der Ultraschallwandlerkörper 4 bzw. 7 bzw. der Auflageflächen 6 sollte der Gehäuseeinsatz 5 eine nur geringfügige Wandungsdicke aufweisen, die eine ausreichende Durchschallung ermöglicht.

Der jeweilige Gehäuseeinsatz 5 kann zudem zur elektrischen Kontaktierung der Ultraschallwandlerkörper 4, 7 mit einer metallischen Beschichtung im Bereich der Auflagefläche 6 versehen sein.

Die akustische Ankopplung der jeweiligen Piezokeramikscheibe an die Wand des Gehäuseeinsatzes 5 erfolgt zweckmäßigerweise mit einer geeigneten Schallleitpaste, beispielsweise aus Silikon oder PFPE. Alternativ kann der Ultraschallwandlerkörper 4, 7 auch eingeklebt sein oder eine Kontaktierung durch Lötung an einer Kontaktschicht des Gehäuseeinsatzes 5 erfolgen. Hierdurch ergibt sich insbesondere eine starre, gut elektrisch leitfähige Verbindung. Die weitere elektrische Kontaktierung auf der Oberseite der Piezokeramikscheibe kann durch die vorzugsweise fest mit der Platine 10 verbundene bzw. mit letzterer verlötete Feder 9, die mit einer definierten Kraft Piezokeramikscheibe gegen die membranartige Wand des Gehäuseeinsatzes 5 drückt, erfolgen.

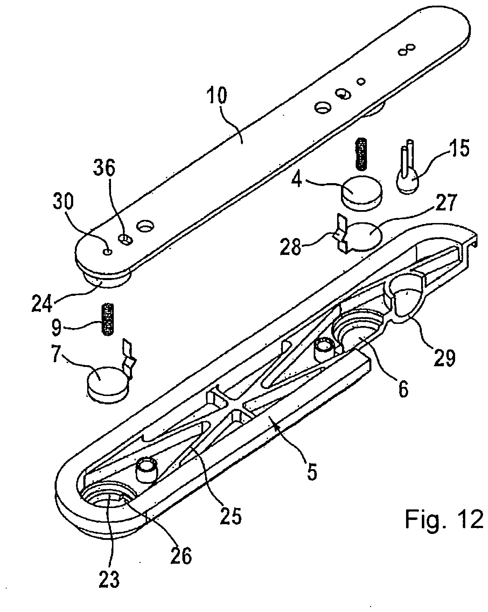

Fig. 12 zeigt eine weitere Ausführungsvariante, bei der der Temperaturfühler 15, z.B. ein sogenanntes NTC-Element, durch die Wandung des Gehäuseeinsatzes 5 hindurch die Temperatur des im Ultraschalldurchflussmesser 1 befindlichen Fluids erfasst. Hierzu ist beispielsweise eine Ausformung 29 im Boden des Gehäuseeinsatzes 5 vorgesehen, in der sich der Temperaturfühler 15 befindet. Letzterer kann über eine (nicht dargestellte) Wärmeleitpaste an die Wandung des Gehäuseeinsatzes 5 thermisch angekoppelt sein. Auf diese Weise entfallen eine Bohrung im Gehäuseeinsatz 5 sowie die Abdichtung zur Innenseite hin. Ferner kann ein nicht gekapseltes NTC-Element verwendet werden, welches im Vergleich zu ersterem erheblich billiger ist.

Die Kontaktierung der Ultraschallwandlerkörper 4 bzw. 7 erfolgt bei dieser Ausgestaltung nicht über eine Metallbeschichtung der Oberfläche des Gehäuseeinsatzes 5, sondern mittels einer Elektrode 27, die aus einer dünnen Metallfolie besteht. Die Elektrode 27 ist mit der Unterseite des Ultraschallwandlerkörpers 4 bzw. 7 fest verbunden beispielsweise verklebt oder verlötet. In Fig. 8 rechte Seite ist die Elektrode zum besseren Verständnis der gesamten Form derselben losgelöst dargestellt. Als Material für die Elektrode 27 kann beispielsweise Edelstahl (VA) oder Kupfer (Cu) vorgesehen sein, welches je nach Weiterbearbeitung mit einer dünnen Edelmetallschicht (z.B. Gold oder Silber) überzogen sein kann. Die an die Elektrode 27 angeformte Anschlussfahne 28 ist vorzugsweise direkt mit der Platine 10 verlötet. Die Anschlussfahne 28 beinhaltet Knicke, die eine nachteilige Kraftübertragung aufgrund Wärmeausdehnung auf die Elektrode 27 verhindern sollen.

Alternativ zu einer festen Verbindung der Elektrode mit dem jeweiligen Ultraschallwandlerkörper 4, 7 kann aufgrund der erfindungsgemäßen Konstruktion in einfacher Weise auch eine lose Anordnung unter Zwischenschaltung einer akustischen Koppelschicht z. B. eines Koppelgels, einer Koppelpaste oder dgl. vorgesehen sein. Hierbei können der jeweilige Ultraschallwandlerkörper 4 bzw. 7 sowie die Elektrode 27 allein durch die Druckkraft der Feder 9 in Position gehalten werden und die elektrische Kontaktierung sichergestellt werden.

Die Anschlussfahne 28 wird zur Vermeidung von unerwünschten elektrischen Kontakten zur Mantelfläche der Piezokeramikscheibe in einem radialen Abstand zum Außendurchmesser der Elektrode 27 umgebogen. Aus diesem Grund ist im Bereich der Fläche 23 eine Ausformung oder Vertiefung 26 vorgesehen. Diese sichert gleichzeitig eine eindeutige Ausrichtung der Elektrode 27 einschließlich Anschlussfahne 28 zu der korrespondierenden Lötbohrung 36 in der Platine 10.

Die Kontaktierung (Signalkontaktierung) erfolgt über die Feder 9, die entweder direkt mit der Platine 10 verlötet ist oder mit einer dort befindlichen Leiterbahn kontaktiert. Für letzteren Fall ist ein Halteteil 24 zur Positionierung der Feder 9 vorgesehen.

Die Darstellungen der Fig. 13B zeigen einen entsprechenden becherförmigen Gehäuseeinsatz 5, bei dem die Kontaktierung des Ultraschallwandlerkörpers 4, welcher ebenfalls eine (in Fig. 13B nicht dargestellte) Metallisierung auf beiden Seiten aufweist, mittels beidseitiger Elektroden 27a sowie 27b, welche jeweils über eine Anschlussfahne 28a bzw. 28b verfügen. Die Anschlussfahnen 28a, 28b verlaufen über beidseitige Vertiefungen 26a, 26b in der Fläche 23 entlang des Gehäuseeinsatzes 5 nach oben und durch Ausschnitte 39a bzw. 39b im Verschlussteil 37 hindurch nach außen. Die Feder 9 sorgt bei dieser Ausgestaltung lediglich für eine mechanische Haltekraft, sie gewährleistet jedoch keine elektrische Kontaktierung. Die oberseitige Elektrode 27b wird eingelegt und lediglich durch Feder 9 in Verbindung mit dem Verschlussteil 37 in Position gehalten. Die Anordnung wird entsprechend der Anordnung nach Fig. 13A in eine Gehäuseöffnung eingesetzt.

Der becherförmige Gehäuseeinsatz 5 kann zusammen mit den darin befindlichen Bauteilen als eigene handhabbare Baueinheit vorproduziert werden.

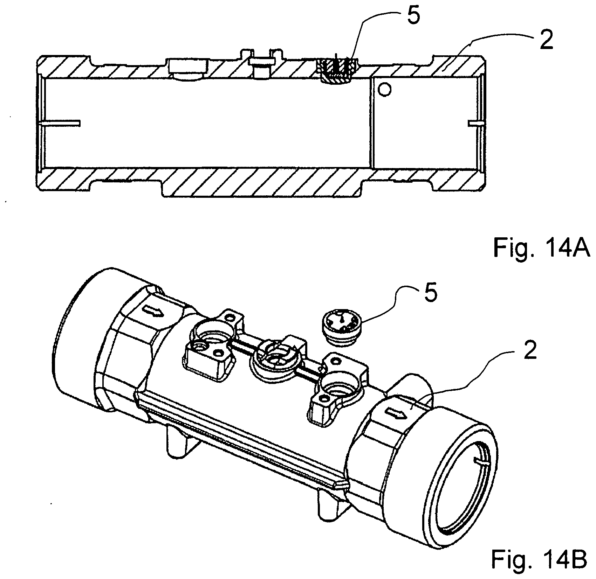

Fig. 14 zeigt ein Gehäuse 2 sowohl in Schnittdarstellung (Fig. 14A) als auch in perspektivischer Darstellung (Fig. 14B) mit zwei oberseitigen Gehäuseöffnungen, in die jeweils ein Gehäuseeinsatz 5 der vorher beschriebenen Art eingesetzt wird. Wie aus Fig. 14A deutlich wird, schließt der Gehäuseeinsatz 5 mit einer Auflageebene für die (nicht dargestellte) Platine etwa bündig ab, so dass eine unmittelbare Kontaktierung durchführbar ist.

### BEZUGSZEICHENLISTE

- 1: Durchflussmesser
- 2: Gehäuse
- 3: Messeinsatz
- 4: Ultraschallwandlerkörper
- 5: Gehäuseeinsatz
- 6: Auflagefläche
- 7: Ultraschallwandlerkörper
- 8: Feder
- 9: Feder
- 10: Platine
- 11: Vergussmasse
- 12: Modul
- 13: Dichtungselement
- 14: Zapfen
- 15: Temperaturfühler
- 16: Gehäuseöffnung
- 17: Stufe
- 18: Fläche
- 19: Gehäuseinnenwand
- 20: Durchtrittsöffnung
- 21: Dom
- 22: Bohrung
- 23: Fläche
- 24: Halteteil
- 25: Versteifungsrippe
- 26: Vertiefung
- 27: Elektrode
- 28: Anschlussfahne
- 29: Ausformung
- 30: Umlenkspiegel
- 31: Umlenkspiegelhalter
- 32: Rahmen
- 33: Bohrung
- 34: Bohrung
- 35: Dichtungselement
- 36: Lötbohrung
- 37: Verschlussteil
- 38: Bohrung
- 39: Ausschnitt
- 40: Metallisierung
- 41: Metallisierung
- 42: Kontaktschicht
- 43: Schallkopplungsmasse
- 44: Leiterstruktur

## Patentansprüche

1. Ultraschall-Durchflussmesser mit einem ein- oder mehrteiligen, aus Kunststoff bestehenden Gehäuse (2), welches dazu vorgesehen ist, an eine das zu messende Medium führende Leitung angeschlossen und von dem zu messenden Medium durchströmt zu werden, und mit einer Ultraschallwandleranordnung, wobei zwei Ultraschallwandler vorgesehen sind, die das Gehäuse (2) durchschallen, mit:
zwei Ultraschallwandlerkörpern (4, 7) mit jeweils einer ersten Hauptfläche auf der dem Medium zugewandten Seite sowie jeweils einer zweiten Hauptfläche auf der dem Medium abgewandten Seite,
ersten, vorzugsweise flächigen Kontaktmitteln zur elektrischen Kontaktierung der ersten Hauptflächen der Ultraschallwandlerkörper (4, 7),
zweiten, vorzugsweise flächigen Kontaktmitteln zur elektrischen Kontaktierung der zweiten Hauptflächen der Ultraschallwandlerkörper (4, 7),
wobei sich die ersten Kontaktmittel der Ultraschallwandlerkörper (4,7) jeweils zwischen dem jeweiligen Ultraschallwandlerkörper (4, 7) und dem zu durchschallenden Gehäuse (2) des Ultraschall-Durchflussmessers befinden und in das Kunststoff-Gehäuse (2), in mindestens ein aus Kunststoff bestehendes Gehäuseteil oder in einen beide Ultraschallwandlerkörper (4,7) aufnehmenden, aus Kunststoff bestehenden Gehäuseeinsatz (5) eingelegt oder dort festgelegt sind.

2. Ultraschall-Durchflussmesser nach Anspruch 1,
**dadurch gekennzeichnet, dass**
als erste Kontaktmittel des jeweiligen Ultraschallwandlerkörpers (4,7) eine lose Elektrode (27) vorgesehen ist.

3. Ultraschall-Durchflussmesser nach Anspruch 1,
**dadurch gekennzeichnet, dass**
die ersten Kontaktmittel eine auf das Gehäuse (2), das Gehäuseteil oder auf den Gehäuseeinsatz (5) aufgebrachte Kontaktschicht (42) sind.

4. Ultraschall-Durchflussmesser nach Anspruch 1,
**dadurch gekennzeichnet, dass**
die ersten Kontaktmittel eine im Gehäuse (2), Gehäuseteil oder im Gehäuseeinsatz (5) verankerte Leiterstruktur (44) sind.

5. Ultraschall-Durchflussmesser nach mindestens einem der vorhergehenden Ansprüche,
**dadurch gekennzeichnet, dass**
der jeweilige Ultraschallwandlerkörper (4,7) unter einer in Axialrichtung wirkenden Vorspannung am Gehäuse (2), Gehäuseteil oder am Gehäuseeinsatz (5) lagefixiert ist.

6. Ultraschall-Durchflussmesser nach Anspruch 5,
**dadurch gekennzeichnet, dass**
zur Lagefixierung des jeweiligen Ultraschallwandlerkörpers (4,7) eine Feder (9) vorgesehen ist, die den Ultraschallwandlerkörper (4,7) auf dessen dem Medium abgewandten Seite kontaktiert.

7. Ultraschall-Durchflussmesser nach mindestens einem der vorhergehenden Ansprüche,
**dadurch gekennzeichnet, dass**
die ersten Kontaktmittel ein Anschlussteil aufweisen oder mit einem solchen kontaktieren.

8. Ultraschall-Durchflussmesser nach Anspruch 7,
**dadurch gekennzeichnet, dass**
als Anschlussteil eine Anschlussfahne (28) vorgesehen ist.

9. Ultraschall-Durchflussmesser nach Anspruch 8,
**dadurch gekennzeichnet, dass**
die Anschlussfahne (28) integraler Bestandteil der ersten Kontaktmittel ist.

10. Ultraschall-Durchflussmesser nach Anspruch 8,
**dadurch gekennzeichnet, dass**
als Kontaktmittel eine Feder (8) vorgesehen ist.

11. Ultraschall-Durchflussmesser nach Anspruch 10,
**dadurch gekennzeichnet, dass** die Feder (8) entlang des Außenumfangs des Ultraschallwandlerkörpers (4,7) verläuft.

12. Ultraschall-Durchflussmesser nach mindesten einem der vorhergehenden Ansprüche,
**dadurch gekennzeichnet, dass**
die ersten und/oder zweiten Kontaktmittel unmittelbar an einer Platine (10) des Ultraschall-Durchflussmessers angeschlossen sind.

13. Ultraschall-Durchflussmesser nach einem der vorhergehenden Ansprüche
**dadurch gekennzeichnet, dass**
das Gehäuse (2) eine Gehäuseöffnung (16) aufweist,
in die Gehäuseöffnung (16) ein topfförmiger, durchschallbarer Gehäuseeinsatz (5) einsetzbar ist und
der Gehäuseeinsatz (5) dazu eingerichtet ist, die Ultraschallwandlerkörper (4, 7) aufzunehmen.

14. Ultraschall-Durchflussmesser nach Anspruch 13,
**dadurch gekennzeichnet, dass**
ein Verschlussteil (37) zum oberseitigen Verschluss des Gehäuseeinsatzes (5) vorgesehen ist.

15. Ultraschall-Durchflussmesser nach einem der vorhergehenden Ansprüche
**dadurch gekennzeichnet, dass**
eine für den ersten und zweiten Ultraschallwandlerkörper (4, 7) gemeinsame gehäuseseitig festgelegte elektrischen Kontaktierung (44) der ersten Hauptfläche vorgesehen ist.

## Claims

1. Ultrasound flowmeter, comprising a one-part or multi-part housing (2), consisting of plastic, which is provided to be connected to a line carrying the medium to be measured and to be flowed through by the medium to be measured, and comprising an ultrasound transducer assembly, wherein two ultrasound transducers are provided which transmit ultrasound through the housing (2), and comprising:
two ultrasound transducer bodies (4, 7) with in each case a first main surface on the side facing the medium and in each case a second main surface on the side facing away from the medium,
first, preferably planar, contact means for electrically contacting the first main surfaces of the ultrasound transducer bodies (4, 7),
second, preferably planar, contact means for electrically contacting the second main surfaces of the ultrasound transducer bodies (4, 7),
wherein the first contact means of the ultrasound transducer bodies (4, 7) are in each case located between the respective ultrasound transducer body (4, 7) and the housing (2), through which ultrasound is to be transmitted, of the ultrasound flowmeter and are placed or fixed in the plastic housing (2), in at least one housing part consisting of plastic or in a housing insert (5) receiving both ultrasound transducer bodies (4, 7) and consisting of plastic.

2. Ultrasound flowmeter according to Claim 1,
**characterized in that**
a loose electrode (27) is provided as the first contact means of the respective ultrasound transducer body (4, 7) .

3. Ultrasound flowmeter according to Claim 1,
**characterized in that**
the first contact means are a contact layer (42) applied to the housing (2), the housing part or to the housing insert (5).

4. Ultrasound flowmeter according to Claim 1,
**characterized in that**
the first contact means are a conductor structure (44) anchored in the housing (2), housing part or in the housing insert (5).

5. Ultrasound flowmeter according to at least one of the preceding claims,
**characterized in that**
the respective ultrasound transducer body (4, 7) is fixed in position on the housing (2), housing part or on the housing insert (5) under a bias acting in the axial direction.

6. Ultrasound flowmeter according to Claim 5,
**characterized in that**
a spring (9), which contacts the ultrasound transducer body (4, 7) on the side thereof facing away from the medium, is provided to fix the respective ultrasound transducer body (4, 7) in position.

7. Ultrasound flowmeter according to at least one of the preceding claims,
**characterized in that**
the first contact means have a connecting part or contact a connecting part.

8. Ultrasound flowmeter according to Claim 7,
**characterized in that**
a connecting lug (28) is provided as a connecting part.

9. Ultrasound flowmeter according to Claim 8,
**characterized in that**
the connecting lug (28) is an integral component of the first contact means.

10. Ultrasound flowmeter according to Claim 8,
**characterized in that**
a spring (8) is provided as contact means.

11. Ultrasound flowmeter according to Claim 10,
**characterized in that**
the spring (8) extends along the outer periphery of the ultrasound transducer body (4, 7).

12. Ultrasound flowmeter according to at least one of the preceding claims,
**characterized in that**
the first and/or second contact means are connected directly to a printed circuit board (10) of the ultrasound flowmeter.

13. Ultrasound flowmeter according to one of the preceding claims
**characterized in that**
the housing (2) has a housing opening (16),
a pot-shaped housing insert (5) through which ultrasound can be transmitted can be introduced into the housing opening (16), and
the housing insert (5) is designed to receive the ultrasound transducer bodies (4, 7).

14. Ultrasound flowmeter according to Claim 13,
**characterized in that**
a closure part (37) is provided to close the upper face of the housing insert (5).

15. Ultrasound flowmeter according to one of the preceding claims
**characterized in that**
an electrical contacting (44) of the first main surface is provided, is fixed on the housing side and is common to the first and second ultrasound transducer bodies (4, 7) .

## Revendications

1. Débitmètre à ultrasons, comprenant un boîtier (2) composé de matière plastique et en une ou de plusieurs parties, lequel est conçu pour être raccordé à une conduite qui conduit le fluide à mesurer et être traversé par un courant du fluide à mesurer, et comprenant un arrangement de transducteurs d'ultrasons, deux transducteurs d'ultrasons étant présents, lesquels sondent le boîtier (2) avec des ultrasons, comprenant :
deux corps de transducteur d'ultrasons (4, 7) ayant respectivement une première surface principale sur le côté qui fait face au fluide ainsi que respectivement une deuxième surface principale sur le côté qui est à l'opposé du fluide,
des premiers moyens de contact, de préférence plats, servant à la mise en contact électrique des premières surfaces principales des corps de transducteur d'ultrasons (4, 7),
des deuxièmes moyens de contact, de préférence plats, servant à la mise en contact électrique des deuxièmes surfaces principales des corps de transducteur d'ultrasons (4, 7),
les premiers moyens de contact des corps de transducteur d'ultrasons (4, 7) se trouvant respectivement entre le corps de transducteur d'ultrasons (4, 7) respectif et le boîtier (2) à sonder avec des ultrasons du débitmètre à ultrasons et étant introduits dans le boîtier (2) en matière plastique, dans au moins une partie de boîtier composée de matière plastique ou dans un insert de boîtier (5) composé de matière plastique, accueillant les deux corps de transducteur d'ultrasons (4, 7), et y étant calés.

2. Débitmètre à ultrasons selon la revendication 1, **caractérisé en ce que** les premiers moyens de contact du corps de transducteur d'ultrasons (4, 7) respectif sont conçus sous la forme d'une électrode libre (27).

3. Débitmètre à ultrasons selon la revendication 1, **caractérisé en ce que** les premiers moyens de contact sont une couche de contact (42) appliquée sur le boîtier (2), la partie de boîtier ou sur l'insert de boîtier (5).

4. Débitmètre à ultrasons selon la revendication 1, **caractérisé en ce que** les premiers moyens de contact sont une structure conductrice (44) ancrée dans le boîtier (2), la partie de boîtier ou dans l'insert de boîtier (5) .

5. Débitmètre à ultrasons selon au moins l'une des revendications précédentes, **caractérisé en ce que** le corps de transducteur d'ultrasons (4, 7) respectif est bloqué en position fixe au niveau du boîtier (2), de la partie de boîtier ou au niveau de l'insert de boîtier (5) sous une précontrainte agissant dans la direction axiale.

6. Débitmètre à ultrasons selon la revendication 5, **caractérisé en ce qu'**un ressort (9) est présent pour le blocage en position fixe du corps de transducteur d'ultrasons (4, 7) respectif, lequel vient en contact avec le corps de transducteur d'ultrasons (4, 7) sur son côté à l'opposé du fluide.

7. Débitmètre à ultrasons selon au moins l'une des revendications précédentes, **caractérisé en ce que** les premiers moyens de contact possèdent une partie de raccordement ou sont en contact avec une telle partie.

8. Débitmètre à ultrasons selon la revendication 7, **caractérisé en ce qu'**une languette de raccordement (28) est présente en tant que partie de raccordement.

9. Débitmètre à ultrasons selon la revendication 8, **caractérisé en ce que** la languette de raccordement (28) fait partie intégrante des premiers moyens de contact.

10. Débitmètre à ultrasons selon la revendication 8, **caractérisé en ce qu'**un ressort (8) est présent en tant que moyens de contact.

11. Débitmètre à ultrasons selon la revendication 10, **caractérisé en ce que** le ressort (8) s'étend le long du pourtour extérieur du corps de transducteur d'ultrasons (4, 7).

12. Débitmètre à ultrasons selon au moins l'une des revendications précédentes, **caractérisé en ce que** les premiers et/ou deuxièmes moyens de contact sont raccordés directement à une platine (10) du débitmètre à ultrasons.

13. Débitmètre à ultrasons selon l'une des revendications précédentes, **caractérisé en ce que** le boîtier (2) possède une ouverture de boîtier (16), un insert de boîtier (5) en forme de pot pouvant être sondé avec des ultrasons peut être inséré dans l'ouverture de boîtier (16) et l'insert de boîtier (5) est conçu pour accueillir les corps de transducteur d'ultrasons (4, 7).

14. Débitmètre à ultrasons selon la revendication 13, **caractérisé en ce qu'**une partie de fermeture (37) servant à la fermeture côté supérieur de l'insert de boîtier (5) est présente.

15. Débitmètre à ultrasons selon l'une des revendications précédentes, **caractérisé en ce qu'**il est prévu une mise en contact (44) électrique de la première surface principale, définie côté boîtier commune pour le premier et le deuxième corps de transducteur d'ultrasons (4, 7).
